# EUROPEAN PATENT APPLICATION

(11) **EP 3 806 242 A1**
(43) Date of publication of application: **14.04.2021**
(21) Application number: 20200843.9
(22) Date of filing: 08.10.2020
(51) Int. Cl.: H01Q 21/00, H05K 1/14, H01Q 23/00, H01Q 21/06, H01Q 3/26

(54) **ANTENNA ELEMENT FOR PHASED ANTENNA ARRAY**

(30) Priority: 08.10.2019 US 201916596548
(71) Applicant: Rockwell Collins, Inc., Cedar Rapids, IA 52498 (US)
(72) Inventor: LOEB, Logan A., Marion, Iowa 52302 (US)
(74) Representative: Dehns

(57) **Abstract**

A phased antenna array includes at least one antenna element (102) individually fabricated via one or more individual antenna element fabrication processes and a printed circuit board (PCB) (104) fabricated via one or more PCB fabrication processes, where the at least one antenna element is coupled to the PCB via one or more post-fabrication processes. The at least one antenna element includes a first antenna element metal layer (200), a second antenna element metal layer (202), an antenna element dielectric layer (204) positioned between the first antenna element metal layer and the second antenna element metal layer and being of a greater thickness than a thickness of at least one of the first antenna element metal layer or the second antenna element metal layer, and one or more antenna element plated vias (206) embedded within the antenna element dielectric layer and coupled to the first antenna element metal layer and the second antenna element metal layer.

## Description

### BACKGROUND

Phased antenna arrays may require many identical antenna elements precisely located relative to one another. As array size increases, standard printed circuit board (PCB) dimensions may be exceeded. For example, the PCB-based, printed metal antenna may include a limited metal geometry (e.g., a 0.003-inch (0.0735mm) minimum line width and space, a limited PCB thickness, or the like) for large boards. The limited metal geometry may not allow for a level of feature fineness and/or tolerance tightness necessary for higher frequency (e.g., greater than 30 Gigahertz (GHz) applications). By way of another example, dielectric thickness may be limited, which may adversely affect performance characteristics including, but not limited to, bandwidth and/or gain. As a result, the current processes for fabricating antenna elements on large PCBs may result in a poor antenna package yield. These and other factors may result in a high cost for fabricating large phased antenna arrays.

### SUMMARY

A phased antenna array is disclosed. In one or more embodiments, the phased antenna array includes at least one antenna element. The at least one antenna element includes a first antenna element metal layer. The at least one antenna element includes a second antenna element metal layer. The at least one antenna element includes an antenna element dielectric layer positioned between the first antenna element metal layer and the second antenna element metal layer. The antenna element dielectric layer is of a greater thickness than a thickness of at least one of the first antenna element metal layer or the second antenna element metal layer. The at least one antenna element includes one or more antenna element plated vias embedded within the antenna element dielectric layer. The one or more antenna element plated vias are coupled to the first antenna element metal layer and the second antenna element metal layer. The phased antenna array includes a printed circuit board (PCB). The at least one antenna element is individually fabricated via one or more individual antenna element fabrication processes. The PCB is fabricated via one or more PCB fabrication processes. The at least one antenna element is coupled to the PCB via one or more post-fabrication processes.

In some embodiments, the at least one antenna element further includes at least one passive device or active device coupled to a surface of at least one of the first antenna element metal layer or the second antenna element metal layer.

In some embodiments, the PCB includes at least two PCB metal layers. The PCB includes a PCB dielectric layer positioned between a first PCB metal layer of the at least two PCB metal layers and a second PCB metal layer of the at least two PCB metal layers. The PCB dielectric layer is of a greater thickness than a thickness of at least one of the first PCB metal layer or the second PCB metal layer. The PCB includes one or more PCB plated vias embedded within the PCB dielectric layer. The one or more PCB plated vias are coupled to the first PCB metal layer and the second PCB metal layer.

In some embodiments, the PCB further includes at least one passive device or active device coupled to a surface of at least one of the first PCB metal layer or the second PCB metal layer.

In some embodiments, the PCB further includes one or more of the at least one antenna element being individually checked for defects or the PCB being checked for defects before the one or more post-fabrication processes.

In some embodiments, the one or more post-fabrication processes include one or more automated pick-and-place processes, and a solder reflow process configured to mount the at least one antenna element to a surface of the PCB.

In some embodiments, the one or more post-fabrication processes include one or more manual pick-and-place processes, and a solder reflow process configured to mount the at least one antenna element to a surface of the PCB.

In some embodiments, the at least one antenna element includes a plurality of antenna elements. Each antenna element of the plurality of antenna elements includes the same antenna element design.

In some embodiments, the at least one antenna element includes a plurality of antenna elements. At least a first antenna element of the plurality of antenna elements includes an antenna element design different from an antenna element design of at least a second antenna element of the plurality of antenna elements.

In some embodiments, the thickness of the antenna element dielectric layer may be selected to achieve at least one of a particular bandwidth value or a gain value for applications utilizing greater than 30 gigahertz (GHz) frequencies.

In some embodiments, the at least one antenna element fabricated with at least one line or space less than 0.001-inch (0.0254mm).

A method for assembling a phased antenna array including at least one antenna element is disclosed, in accordance with one or more embodiments of the disclosure. The method may include, but is not limited to, individually fabricating at least one antenna element via one or more individual antenna element fabrication processes. The at least one antenna element includes a first antenna element metal layer. The at least one antenna element includes a second antenna element metal layer. The at least one antenna element includes an antenna element dielectric layer positioned between the first antenna element metal layer and the second antenna element metal layer. The at least one antenna element includes one or more antenna element plated vias embedded within the antenna element dielectric layer. The one or more antenna element plated vias are coupled to the first antenna element metal layer and the second antenna element metal layer. The method may include, but is not limited to, fabricating a printed circuit board (PCB) via one or more PCB fabrication processes. The method may include, but is not limited to, coupling the at least one antenna element to the PCB via one or more post-fabrication processes.

In some embodiments, the method may include, but is not limited to, at least one of individually checking the at least one antenna element for defects before the one or more post-fabrication processes, or checking the PCB for defects before the one or more post-fabrication processes.

In some embodiments, the method may include, but is not limited to, one or more automated pick-and-place processes, and a solder reflow process configured to mount the at least one antenna element to a surface of the PCB.

In some embodiments, the method may include, but is not limited to, one or more manual pick-and-place processes, and a solder reflow process configured to mount the at least one antenna element to a surface of the PCB.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are examples and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a perspective view illustrating an antenna element for phased antenna array, in accordance with one or more embodiments of the disclosure;
FIG. 2 is a partial cross-section view illustrating the antenna element for phased antenna array of FIG. 1, in accordance with one or more embodiments of the disclosure;
FIG. 3 is a perspective view illustrating a phased antenna array including multiples of the antenna element for phased antenna array of FIG. 1, in accordance with one or more embodiments of the disclosure;
FIG. 4 is a flow diagram illustrating a method for fabricating the antenna element for phased antenna array of FIG. 1 and/or the phased antenna array in FIG. 3, in accordance with one or more embodiments of the disclosure; and
FIG. 5 is a block diagram illustrating an aircraft with a controller in communication with the antenna element for phased antenna array of FIG. 1, in accordance with one or more embodiments of the disclosure.

### DETAILED DESCRIPTION OF THE INVENTION

Reference will now be made in detail to the subject matter disclosed, which is illustrated in the accompanying drawings.

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1 a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by anyone of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination of sub-combination of two or more such features, along with any other features which may not necessarily be expressly described or inherently present in the instant disclosure.

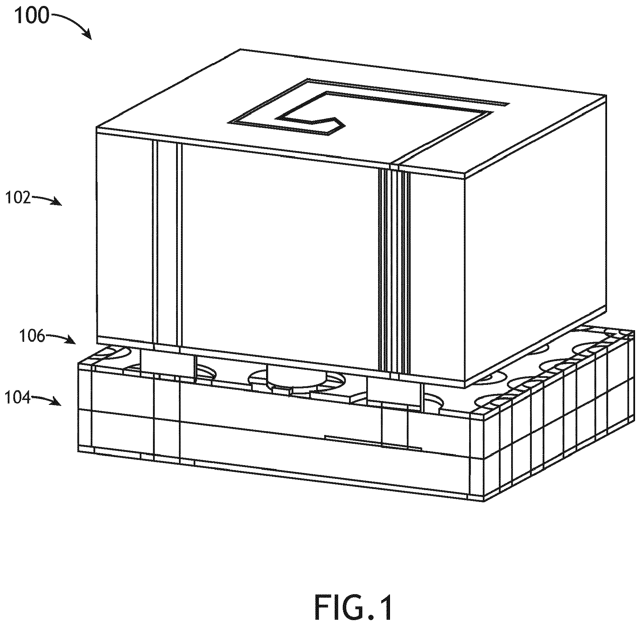

FIGS. 1-5 generally illustrate an antenna package 100 for phased antenna array, in accordance with one or more embodiments of the disclosure. It is noted herein that "antenna package 100" and variants of the term "antenna package 100" (e.g., "antenna 100", "package 100", or the like) may be considered equivalent for purposes of the disclosure.

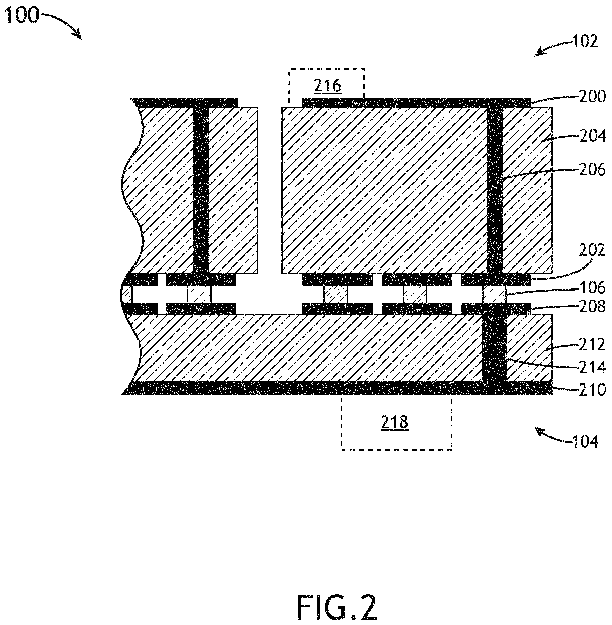

FIGS. 1 and 2 generally illustrate the antenna package 100 for phased antenna array, in accordance with one or more embodiments of the disclosure.

The antenna package 100 may include an antenna element 102. The antenna element 102 may be coupled (e.g., physically and/or electrically) to a printed circuit board 104 (PCB 104). For example, the antenna element 102 may be surface-mounted onto the PCB 104 via solder attach 106.

The antenna element 102 may include a first antenna element layer 200 and a second antenna element layer 202. The first antenna element layer 200 and the second antenna element layer 202 may be separated by an antenna element dielectric layer 204. One or more antenna element plated vias 206 may be embedded within (e.g., pass through) the antenna element dielectric layer 204. The one or more antenna element plated vias 206 may electrically couple the first antenna element layer 200 and the second antenna element layer 202.

The antenna element 102 may include one or more antenna element passive devices 216 (e.g., resistors, or the like) or active devices 216 (e.g., amplifiers, or the like). For example, the one or more antenna element passive or active devices 216 may be coupled (e.g., physically and/or electrically) to a surface of the first antenna element layer 200 and/or the second antenna element layer 202. By way of another example, the one or more antenna element passive or active devices 216 may be embedded within the antenna element 102 (e.g., embedded within the antenna element dielectric layer 204).

The PCB 104 may include a first PCB layer 208 and a second PCB layer 210. The first PCB layer 208 and the second PCB layer 210 may be separated by a PCB dielectric layer 212. One or more PCB plated vias 214 may be embedded within (e.g., pass through) the PCB dielectric layer 212. The one or more PCB plated vias 214 may electrically couple the first PCB layer 208 and the second PCB layer 210.

The PCB 104 may include one or more PCB passive devices 218 (e.g., resistors, or the like) or active devices 218 (e.g., amplifiers, or the like). For example, the one or more PCB passive or active devices 218 may be coupled (e.g., physically and/or electrically) to a surface of the first PCB layer 208 and/or the second PCB layer 210. By way of another example, the one or more PCB passive or active devices 218 may be embedded within the PCB 104 (e.g., embedded within the PCB dielectric layer 212).

The first antenna element layer 200, the second antenna element layer 202, the first PCB layer 208, and the second PCB layer 210 may be of a thickness known in the art that is usable for high-frequency applications. For example, the first antenna element layer 200, the second antenna element layer 202, the first PCB layer 208, and the second PCB layer 210 may be of a substantially equal thickness. By way of another example, at least one of the first antenna element layer 200, the second antenna element layer 202, the first PCB layer 208, and the second PCB layer 210 may be of a different thickness than the remainder of the first antenna element layer 200, the second antenna element layer 202, the first PCB layer 208, and the second PCB layer 210.

The first antenna element layer 200, the second antenna element layer 202, the first PCB layer 208, and the second PCB layer 210 may be fabricated from any conductive material (e.g., a metal, or the like) known in the art that is usable for high-frequency applications. For example, the first antenna element layer 200, the second antenna element layer 202, the first PCB layer 208, and the second PCB layer 210 may be fabricated from the same conductive material. By way of another example, at least one of the first antenna element layer 200, the second antenna element layer 202, the first PCB layer 208, and the second PCB layer 210 may be fabricated from a different conductive material than the remainder of the first antenna element layer 200, the second antenna element layer 202, the first PCB layer 208, and the second PCB layer 210.

The antenna element dielectric layer 204 and the PCB dielectric layer 212 may be fabricated from any dielectric material known in the art (e.g., a nonconductive elastomer, or the like) that is usable for high-frequency applications. For example, the antenna element dielectric layer 204 and the PCB dielectric layer 212 may be fabricated from the same dielectric material. By way of another example, the antenna element dielectric layer 204 and the PCB dielectric layer 212 may be fabricated from different dielectric materials.

The antenna element dielectric layer 204 and the PCB dielectric layer 212 may be of a thickness known in the art that is usable for high-frequency applications. For example, the antenna element dielectric layer 204 and/or the PCB dielectric layer 212 may be of a thickness selected to achieve a performance characteristic including, but not limited to, a particular bandwidth value, gain value, or the like. The antenna element dielectric layer 204 and the PCB dielectric layer 212 may be of a substantially equal thickness. By way of another example, the antenna element dielectric layer 204 and the PCB dielectric layer 212 may be different thicknesses.

The first antenna element layer 200 and/or the second antenna element layer 202 may have a limited geometry (e.g., line width, spaces, thickness, or the like). For example, the line width and/or the spaces may be less than 0.001-inch (0.0254mm). It is noted herein the thickness of the antenna element dielectric layer 204 may be of greater thickness when compared to the thickness of the first antenna element layer 200 and/or the thickness of the second antenna element layer 202.

The first PCB layer 208 and the second PCB layer 210 may have a small geometry (e.g., line width, spaces, thickness, or the like). For example, the line width and/or the spaces may be less than 0.001-inch (0.0254mm). It is noted herein the thickness of the PCB dielectric layer 212 may be of greater thickness when compared to the thickness of the first PCB layer 208 and/or the second PCB layer 210.

The one or more antenna element plated vias 206 and the one or more PCB plated vias 214 may be fabricated from any conductive material (e.g., a metal, or the like) known in the art that is usable for high-frequency applications. For example, the plated vias 206, 214 may be fabricated from the same conductive material. By way of another example, the plated vias 206, 214 may be fabricated from different conductive materials.

Although some embodiments of the disclosure are directed to the first antenna element layer 200 and/or the second antenna element layer 202 sitting on an exterior surface of the antenna element dielectric layer 204 (e.g., as illustrated in FIG. 2), it is noted herein that the first antenna element layer 200 and/or the second antenna element layer 202 may be at least partially embedded within the antenna element dielectric layer 204.

Although some embodiments of the disclosure are directed to the first PCB layer 208 and/or the second PCB layer 210 sitting on an exterior surface of the PCB dielectric layer 212 (e.g., as illustrated in FIG. 2), it is noted herein that the first PCB layer 208 and/or the second PCB layer 210 may be at least partially embedded within the PCB dielectric layer 212.

It is noted herein that the antenna element 102 may include antenna element layers in addition to the first antenna element layer 200, the second antenna element layer 202, and the antenna element dielectric layer 204. Therefore, the above description should not be interpreted as a limitation on the scope of the present disclosure but merely an illustration. In addition, it is noted herein that the PCB 104 may include PCB layers in addition to the first PCB layer 208, the second PCB layer 210, and the PCB dielectric layer 212. Therefore, the above description should not be interpreted as a limitation on the scope of the present disclosure but merely an illustration.

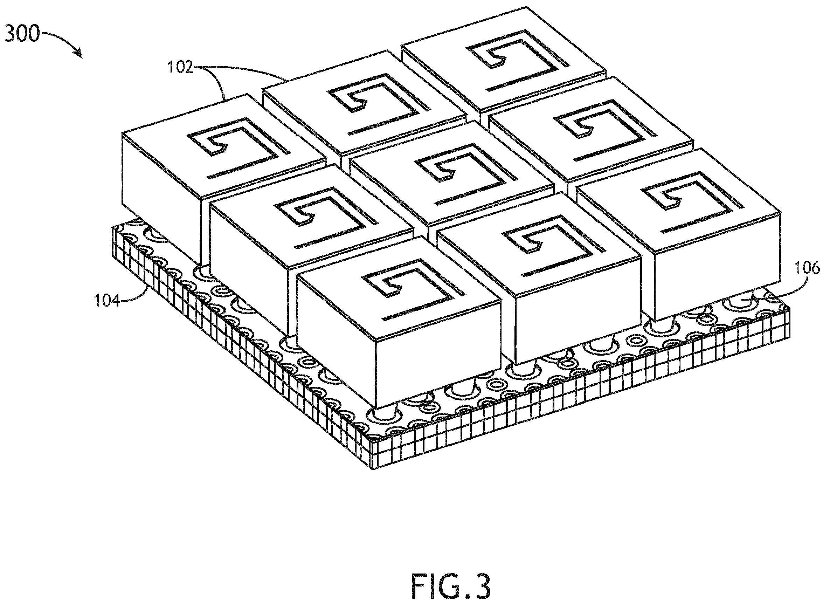

FIG. 3 is a perspective view illustrating a phased antenna array 300 including multiple antenna elements 102 for phased antenna array, in accordance with one or more embodiments of the disclosure.

The phased antenna array 300 may include multiple antenna elements 102 coupled (e.g., physically and/or electrically) to a PCB 104 via solder attach 106. Where there are multiple antenna elements 102 coupled (e.g., physically and/or electrically) to one PCB 104, the PCB 104 may include a greater number of PCB plated vias 214 as compared to a number of PCB plated vias 214 of a particular antenna element 102.

All of the multiple antenna elements 102 may have the same antenna element design/layout/configuration, where the antenna element design/layout/configuration includes the same one or more operating parameters and/or arrangement of components (e.g., of the first antenna element layer 200, the second antenna element layer 202, the antenna element dielectric layer 204, the one or more antenna element plated vias 206, the one or more antenna passive or active devices 216, or the like) selected for a particular operating frequency and level of desired performance. It is noted herein, however, that at least one of the multiple antenna elements 102 may have a different antenna element design/layout/configuration from the remainder of the multiple antenna elements 102. In addition, it is noted herein that none of the multiple antenna elements 102 may have the same antenna element design/layout/configuration.

The multiple antenna elements 102 may be positioned on the PCB 104 in a particular pattern or formation (e.g., a grid pattern or formation, or other two-dimensional (2D) shape-based arrangement known in the art). For example, sets of adjacent antenna elements 102 of the multiple antenna elements 102 may be separated by the same distance. It is noted herein, however, that at least one of the multiple antenna elements 102 may be positioned on the PCB 104 offset from the other multiple antenna elements 102. For example, a set of adjacent antenna elements 102 of the multiple antenna elements 102 may be separated a different distance than the other sets of adjacent antenna elements 102 of the multiple antenna elements 102. In addition, it is noted herein the multiple antenna elements 102 may be positioned at random on the PCB 104. For example, no set of adjacent antenna elements 102 of the multiple antenna elements 102 may be separated the same distance than any other set of adjacent antenna elements 102 of the multiple antenna elements 102.

The multiple antenna elements 102 may be oriented on the PCB 104 in the same direction. It is noted herein, however, that at least one of the multiple antenna elements 102 may be oriented on the PCB 104 in a different direction from the remainder of the multiple antenna elements 102. In addition, it is noted herein that all antenna elements 102 of the multiple antenna elements 102 may be oriented in a different direction on the PCB 104, such that no two antenna elements 102 of the multiple antenna elements 102 are oriented in the same direction.

The PCB 104 may include a PCB design/layout/configuration including one or more operating parameters and/or arrangement of components (e.g., of the first PCB layer 208, the second PCB layer 210, the PCB dielectric layer 212, the one or more PCB plated vias 214, the one or more PCB passive or active devices 218, or the like). For example, the PCB 104 may include one or more power divider networks and/or active circuitry.

It is noted herein that the phased antenna array 300 may be considered an antenna package 100 for purposes of the present disclosure. In addition, it is noted herein the multiple antenna elements 102 (or a single antenna element 102) may be considered as forming an "antenna element layer" of the phased antenna array 300 or the antenna package 100, for purposes of the disclosure. Further, it is noted herein the PCB 104 may be considered as forming a "radio frequency (RF) distribution layer" of the phased antenna array 300, for purposes of the disclosure.

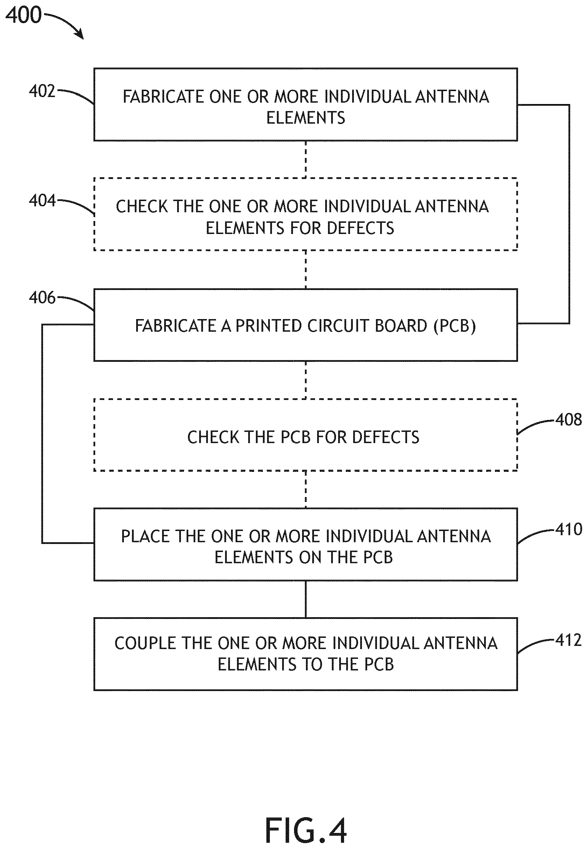

FIG. 4 is a flow diagram illustrating a method 400 for fabricating the antenna package 100 and/or the phased antenna array 300, in accordance with one or more embodiments of the disclosure.

In a step 402, one or more individual antenna elements 102 are fabricated via one or more fabrication processes. The one or more individual antenna elements 102 may include an antenna element design/layout/configuration including one or more operating parameters and/or arrangement of components (e.g., of the first antenna element layer 200, the second antenna element layer 202, the antenna element dielectric layer 204, the one or more antenna element plated vias 206, the one or more antenna element passive or active devices 216, or the like) selected for a particular operating frequency and level of desired performance. Should multiple antenna elements 102 be fabricated, all, some, or none of the multiple antenna elements 102 may have the same antenna element design/layout/configuration (e.g., the same one or more parameters selected for a particular operating frequency and level of desired performance).

It is noted herein that fabricating the one or more antenna elements 102 individually may allow for the removal of antenna element layers, simplifying a stack-up of a build (e.g., the phased antenna array 300) including the one or more antenna elements 102. It is noted herein that fabricating the one or more antenna elements 102 individually may allow for the removing and/or replacing of a particular antenna element 102 without interfering with the remainder of the build including the one or more antenna elements 102.

In a step 404, the one or more individual antenna elements 102 are checked (e.g., inspected, screened, or the like) for defects. It is noted herein that fabricating the one or more antenna elements 102 individually may allow for the checking for defects and removal from the build (e.g., the phased antenna array 300) prior to assembly of the build.

In a step 406, a PCB 104 is fabricated via one or more fabrication processes. The PCB 104 may be configured to electrically couple to the one or more individual antenna elements 102. The PCB 104 may include a PCB design/layout/configuration including one or more operating parameters and/or arrangement of components (e.g., of the first PCB layer 208, the second PCB layer 210, the PCB dielectric layer 212, the one or more PCB plated vias 214, the one or more PCB passive or active devices 218, or the like) selected for a particular operating frequency and level of desired performance. For example, the PCB 104 may include one or more power divider networks and/or active circuitry.

In a step 408, the PCB 104 is checked (e.g., inspected, screened, or the like) for defects.

It is noted herein that the checking step 404 and/or the checking step 408 may cause issues with the one or more individual antenna elements 102 becoming de-tuned after fabrication. However, it is contemplated a test rig or test socket may be designed and implemented to accommodate (e.g., prevent, offset, or the like) the possible de-tuning of the one or more individual antenna elements 102.

In a step 410, the one or more individual antenna elements 102 are placed on the PCB 104. The one or more individual antenna elements 102 may be placed on the PCB 104 via one or more pick-and-place processes. For example, the one or more pick-and-place processes may be automated (e.g., performed by a programmed machine). By way of another example, the one or more pick-and-place processes may be manual (e.g., performed via hand assembly).

It is noted herein that placing the one or more individual antenna elements 102 on the PCB 104 via the one or more pick-and-place processes may allow for the mix-and-match of antenna elements 102 fabricated with different microelectronic packaging technologies in the antenna element layer of the phased antenna array 300. In addition, it is noted herein that placing the one or more individual antenna elements 102 on the PCB 104 via the one or more pick-and-place processes may allow for the mix-and-match of low-cost PCB technology in the RF distribution layer of the phased antenna array 300.

In a step 412, the one or more individual antenna elements 102 are coupled (e.g., physically and/or electrically) to the PCB 104 via one or more fabrication processes. The one or more individual antenna elements 102 may be coupled to the PCB 104 via a single fabrication process (e.g., via automated or manual reflow of the solder attach 106) The one or more individual antenna elements 102 may be coupled to the PCB 104 via one or more simultaneous or substantially simultaneous fabrication processes. It is noted herein, however, that at least some of the one or more processes may be performed in sequential order instead of simultaneously.

It is noted herein the one or more fabrication processes to fabricate the one or more individual antenna elements 102, fabricate the PCB 104, and/or couple the one or more individual antenna elements 102 to the PCB 104 may include, but are not limited to, one or more microelectronic packaging techniques, one or more PCB techniques (e.g., screen printing, or the like), one or more substrate drilling techniques, three-dimensional (3D) printing, injection molding, one or more lower temperature co-fired ceramic techniques, or the like.

In this regard, the disclosure is directed to an antenna element for phased antenna array, with individual fabrication of the antenna elements 102 and subsequent placing/coupling of the individual antenna elements 102 onto the PCB 104. The individual fabrication of the antenna elements 102 may result in cost savings by checking for defective individual antenna elements 102 prior to the placing of the individual antenna elements 102 on and the coupling of the individual antenna elements 102 to the PCB 104. The individual fabrication of the antenna elements 102 may result in cost savings by simplifying the PCB 104. The individual fabrication of the antenna elements 102 may result in cost savings by checking for defective PCB 104 fabrication builds prior to the placing of the individual antenna elements 102 on and the coupling of the individual antenna elements 102 to the PCB 104. This, in turn, may result in improved performance of the antenna package 100 and/or the phased antenna array 300 with the removal of defective antenna elements 102.

The method 400 is not limited to the steps and/or sub-steps provided. The method 400 may include more or fewer steps and/or sub-steps. For example, one or more of the checking step 404 and/or the checking step 408 may not be performed. The method 400 may perform the steps and/or sub-steps in an order other than provided. For example, at least some of the steps 402, 404, 406, 408 may be performed in series (e.g., fabricating step 402 then checking step 404, fabricating step 406, or checking step 408; fabricating step 406 then fabricating step 402, checking step 404, or checking step 408; checking step 404 then fabricating step 406 or checking step 408; checking step 408 then fabricating step 402 or checking step 404, or the like). By way of another example, a number of the steps 402, 404, 406, 408 may be performed in parallel (e.g., fabricating step 402 and fabricating step 406 or checking step 408; fabricating step 406 and checking step 402 or checking step 404, checking step 404 and fabricating step 406 or checking step 408; checking step 408 and fabricating step 402 or checking step 404, or the like). By way of another example, one or more of the checking step 404 and/or the checking step 408 may be performed after the placing step 410 and/or the coupling step 412, due to the removability and replaceability of the individual antenna elements 102. Therefore, the above description should not be interpreted as a limitation on the scope of the present disclosure but merely an illustration.

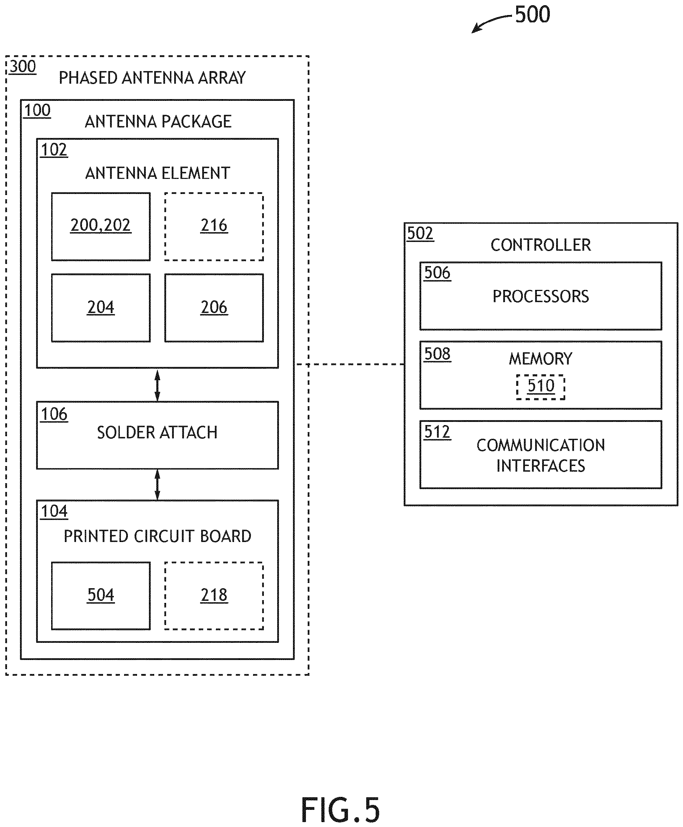

FIG. 5 is a block diagram illustrating an aircraft 500 with a controller 504 in communication with the antenna package 100 for phased antenna array, in accordance with one or more embodiments of the disclosure.

The aircraft 500 may include one or more antenna elements 102. For example, the aircraft 500 may include one or more antenna packages 100, where each antenna package 100 includes one antenna element 102. By way of another example, the aircraft 500 may include one or more phased antenna arrays 300, where each phased antenna array 300 includes multiple antenna elements 102.

The one or multiple antenna elements 102 may be coupled (e.g., physically and/or electrically) to the PCB 104 via solder attach 106. For example, the one or more multiple antenna elements 102 may be surface-mounted to the PCB 104. The one or more multiple antenna elements 102 may include any of the first antenna element layer 200, the second antenna element layer 202, the antenna element dielectric layer 204, the one or more plated vias 206, and/or the one or more antenna element passive devices 216 or the antenna element active devices 216.

The PCB 104 may include one or more sets of radio frequency (RF) distribution circuitry 504. One or more signals may be transmitted and/or received between the one or multiple antenna elements 102 and the PCB 104 via the solder attach 106. For example, the one or more signals may include one or more radio frequency (RF) signals. By way of another example, the one or more signals may include one or more controls signals.

The one or more PCB passive devices 218 or the one or more PCB active devices 218 of the PCB 104 may interpret control signals received from the aircraft 500 (e.g., via the one or more controllers 502). The one or more PCB passive devices 218 or the one or more PCB active devices 218 of the PCB 104 may control one or more components of the phased antenna array 300. The one or more PCB passive devices 218 or the one or more PCB active devices 218 of the PCB 104 may provide power to the phased antenna array 300. Power and/or control signals may be provided from the one or more PCB passive devices 218 or the one or more PCB active devices 218 of the PCB 104 to the one or multiple antenna elements 102 via the solder attach 106.

The one or more antenna packages 100 and/or the one or more phased antenna arrays 300 may be coupled (e.g., physically, electrically, and/or communicatively) to the one or more controllers 502. The one or more controllers 502 may be housed within the aircraft 500. It is noted herein, however, that the one or more controllers 502 may be offboard the aircraft 500 (e.g., in possession of an air traffic control tower, in possession of an offboard ground maintenance crew, in possession of a manufacturing line operator, in possession of a quality control tester, or the like).

For example, the one or more antenna packages 100 and/or the one or more phased antenna arrays 300 may be configured to transmit data to and/or receive data from the onboard one or more controllers 502 and/or the offboard one or more controllers 502. By way of another example, the one or more antenna packages 100 and/or the one or more phased antenna arrays 300 may be configured to record event logs and may transmit the event logs to the onboard one or more controllers 502 and/or the offboard one or more controllers 502. By way of another example, the one or more controllers 502 may be configured to receive information and/or commands from the onboard one or more controllers 502 and/or the offboard one or more controllers 502, either in response to (or independent of) the transmitted event logs.

The one or more controllers 502 may include at least one of one or more processors 506, memory 508 configured to store one or more sets of program instructions 510, and/or one or more communication interfaces 512.

The one or more processors 506 provides processing functionality for at least the one or more controllers 502 and may include any number of processors, micro-controllers, circuitry, field programmable gate array (FPGA) or other processing systems, and resident or external memory for storing data, executable code, and other information accessed or generated by the one or more controllers 502. The one or more processors 506 may execute one or more software programs (e.g., the one or more sets of program instructions 510) embodied in a non-transitory computer readable medium (e.g., the memory 508) that implement techniques described herein. The one or more processors 506 are not limited by the materials from which it is formed or the processing mechanisms employed therein and, as such, may be implemented via semiconductor(s) and/or transistors (e.g., using electronic integrated circuit (IC) components), and so forth.

The memory 508 may be an example of tangible, computer-readable storage medium that provides storage functionality to store various data and/or program code associated with operation of the one or more controllers 502 and/or one or more processors 506, such as software programs and/or code segments, or other data to instruct the one or more processors 506 and/or other components of the one or more controllers 502, to perform the functionality described herein. Thus, the memory 508 may store data, such as a program of instructions for operating the one or more controllers 502, including its components (e.g., one or more processors 506, the one or more communication interfaces 512, or the like), and so forth. It should be noted that while a single memory 508 is described, a wide variety of types and combinations of memory (e.g., tangible, non-transitory memory) may be employed. The memory 508 may be integral with the one or more processors 506, may include stand-alone memory, or may be a combination of both. Some examples of the memory 508 may include removable and non-removable memory components, such as random-access memory (RAM), read-only memory (ROM), flash memory (e.g., a secure digital (SD) memory card, a mini-SD memory card, and/or a micro-SD memory card), solid-state drive (SSD) memory, magnetic memory, optical memory, universal serial bus (USB) memory devices, hard disk memory, external memory, and so forth.

The one or more controllers 502 may be configured to perform one or more process steps, as defined by the one or more sets of program instructions 510. The one or more process steps may be performed iteratively, concurrently, and/or sequentially. The one or more sets of program instructions 510 may be configured to operate via a control algorithm, a neural network (e.g., with states represented as nodes and hidden nodes and transitioning between them until an output is reached via branch metrics), a kernel-based classification method, a Support Vector Machine (SVM) approach, canonical-correlation analysis (CCA), factor analysis, flexible discriminant analysis (FDA), principal component analysis (PCA), multidimensional scaling (MDS), principal component regression (PCR), projection pursuit, data mining, prediction-making, exploratory data analysis, supervised learning analysis, boolean logic (e.g., resulting in an output of a complete truth or complete false value), fuzzy logic (e.g., resulting in an output of one or more partial truth values instead of a complete truth or complete false value), or the like. For example, in the case of a control algorithm, the one or more sets of program instructions 510 may be configured to operate via proportional control, feedback control, feedforward control, integral control, proportional-derivative (PD) control, proportional-integral (PI) control, proportional-integral-derivative (PID) control, or the like.

The one or more communication interfaces 512 may be operatively configured to communicate with components of the one or more controllers 502. For example, the one or more communication interfaces 512 may be configured to retrieve data from the one or more processors 506 or other devices, transmit data for storage in the memory 508, retrieve data from storage in the memory 508, and so forth. The one or more communication interfaces 512 may also be coupled (e.g., physically, electrically, and/or communicatively) with the one or more processors 506 to facilitate data transfer between components of the one or more controllers 502 and the one or more processors 506. It should be noted that while the one or more communication interfaces 512 is described as a component of the one or more controllers 502, one or more components of the one or more communication interfaces 512 may be implemented as external components coupled (e.g., physically, electrically, and/or communicatively) to the one or more controllers 502 via a wired and/or wireless connection. The one or more controllers 502 may also include and/or connect to one or more input/output (I/O) devices. In some embodiments, the one or more communication interfaces 512 includes or is coupled (e.g., physically, electrically, and/or communicatively) to a transmitter, receiver, transceiver, physical connection interface, or any combination thereof.

The one or more controllers 502 may be coupled (e.g., physically, electrically, and/or communicatively) to one or more user interfaces. The one or more user interfaces may include and/or be configured to interact with one or more display devices. The one or more user interfaces may include and/or be configured to interact with one or more data input devices.

The one or more communication interfaces 512 may be operatively configured to communicate with one or more user interfaces. The one or more controllers 502 and the one or more user interfaces may be separate components (e.g., have separate housings and/or separate chassis). It is noted herein, however, that the one or more controllers 502 and the one or more user interfaces may be components integrated in a single housing and/or on a single chassis.

The one or more display devices may include any display device known in the art. For example, the one or more display devices may include, but are not limited to, a liquid crystal display (LCD), a light-emitting diode (LED) display, an organic light-emitting diode (OLED) based display, or the like. Those skilled in the art should recognize that a variety of display devices may be suitable for implementation in the disclosure and the particular choice of display device may depend on a variety of factors, including, but not limited to, form factor, cost, and the like. In a general sense, any display device capable of integration with the one or more data input devices (e.g., touchscreen, bezel mounted interface, keyboard, mouse, trackpad, and the like) is suitable for implementation in the disclosure.

The one or more data input devices may include any data input device known in the art. For example, the one or more data input devices may include, but are not limited to, a keyboard, a keypad, a touchscreen, a lever, a knob, a scroll wheel, a track ball, a switch, a dial, a sliding bar, a scroll bar, a slide, a touch pad, a paddle, a steering wheel, a joystick, a button, a bezel input device or the like. In the case of a touchscreen interface, those skilled in the art should recognize that a large number of touchscreen interfaces may be suitable for implementation in the disclosure. For instance, a display device may be integrated with a touchscreen interface, such as, but not limited to, a capacitive touchscreen, a resistive touchscreen, a surface acoustic based touchscreen, an infrared based touchscreen, or the like. In a general sense, any touchscreen interface capable of integration with the display portion of a display device is suitable for implementation in the disclosure.

It is noted herein the aircraft 500, the one or more controllers 502, and/or the one or more user interfaces (and/or select components of the aircraft 500, the one or more controllers 502, and/or the one or more user interfaces) may be configured in accordance with guidelines and/or standards put forth by, but not limited to, the Federal Aviation Administration (FAA), the European Aviation Safety Agency (EASA) or any other flight certification agency or organization; the American National Standards Institute (ANSI), Aeronautical Radio, Incorporated (ARINC), or any other standards setting organization or company; the Radio Technical Commission for Aeronautics (RTCA) or any other guidelines agency or organization; or the like.

Although inventive concepts have been described with reference to the embodiments illustrated in the attached drawing figures, equivalents may be employed and substitutions made herein without departing from the scope of the claims. Components illustrated and described herein are merely examples of a system/device and components that may be used to implement embodiments of the inventive concepts and may be replaced with other devices and components without departing from the scope of the claims. Furthermore, any dimensions, degrees, and/or numerical ranges provided herein are to be understood as nonlimiting examples unless otherwise specified in the claims.

## Claims

1. A phased antenna array, comprising:
at least one antenna element (102), comprising:
a first antenna element metal layer (200);
a second antenna element metal layer (202);
an antenna element dielectric layer (204) positioned between the first antenna element metal layer and the second antenna element metal layer, the antenna element dielectric layer being of a greater thickness than a thickness of at least one of the first antenna element metal layer or the second antenna element metal layer; and
one or more antenna element plated vias (206) embedded within the antenna element dielectric layer, the one or more antenna element plated vias coupled to the first antenna element metal layer and the second antenna element metal layer; and
a printed circuit board, PCB, (104),
the at least one antenna element being individually fabricated via one or more individual antenna element fabrication processes,
the PCB being fabricated via one or more PCB fabrication processes,
the at least one antenna element being coupled to the PCB via one or more post-fabrication processes.

2. The phased antenna array of Claim 1, the at least one antenna element further comprising:
at least one passive device or active device (216) coupled to a surface of at least one of the first antenna element metal layer or the second antenna element metal layer.

3. The phased antenna array of Claim 1 or 2, the PCB comprising:
at least two PCB metal layers (208, 210);
a PCB dielectric layer (212) positioned between a first PCB metal layer of the at least two PCB metal layers and a second PCB metal layer of the at least two PCB metal layers, the PCB dielectric layer being of a greater thickness than a thickness of at least one of the first PCB metal layer or the second PCB metal layer; and
one or more PCB plated vias (214) embedded within the PCB dielectric layer, the one or more PCB plated vias coupled to the first PCB metal layer and the second PCB metal layer.

4. The phased antenna array of Claim 3, the PCB further comprising:
at least one passive device or active device (218) coupled to a surface of at least one of the first PCB metal layer or the second PCB metal layer.

5. The phased antenna array of any preceding Claim, one or more of the at least one antenna element being individually checked for defects or the PCB being checked for defects before the one or more post-fabrication processes.

6. The phased antenna array of any preceding Claim, the one or more post-fabrication processes comprising:
one or more automated pick-and-place processes; and
a solder reflow process configured to mount the at least one antenna element to a surface of the PCB.

7. The phased antenna array of any preceding Claim, the one or more post-fabrication processes comprising:
one or more manual pick-and-place processes; and
a solder reflow process configured to mount the at least one antenna element to a surface of the PCB.

8. The phased antenna array of any preceding Claim, the at least one antenna element including a plurality of antenna elements, each antenna element of the plurality of antenna elements including the same antenna element design.

9. The phased antenna array of any of Claims 1 to 7, the at least one antenna element including a plurality of antenna elements, at least a first antenna element of the plurality of antenna elements including an antenna element design different from an antenna element design of at least a second antenna element of the plurality of antenna elements.

10. The phased antenna array of any preceding Claim, the thickness of the antenna element dielectric layer being selected to achieve at least one of a particular bandwidth value or a gain value for applications utilizing greater than 30 gigahertz (GHz) frequencies.

11. The phased antenna array of any preceding Claim, the at least one antenna element fabricated with at least one line or space less than 0.001-inch (0.0254mm).

12. A method for assembling a phased antenna array including at least one antenna element, comprising:
individually fabricating at least one antenna element (102) via one or more individual antenna element fabrication processes, the at least one antenna element comprising:
a first antenna element metal layer (200);
a second antenna element metal layer (202);
an antenna element dielectric layer (204) positioned between the first antenna element metal layer and the second antenna element metal layer; and
one or more antenna element plated vias (206) embedded within the antenna element dielectric layer, the one or more antenna element plated vias coupled to the first antenna element metal layer and the second antenna element metal layer;
fabricating a printed circuit board, PCB (104) via one or more PCB fabrication processes; and
coupling the at least one antenna element to the PCB via one or more post-fabrication processes.

13. The method of Claim 12, further comprising at least one of:
individually checking the at least one antenna element for defects before the one or more post-fabrication processes; or
checking the PCB for defects before the one or more post-fabrication processes.

14. The method of Claim 12 or 13, the one or more post-fabrication processes comprising:
one or more automated pick-and-place processes; and
a solder reflow process configured to mount the at least one antenna element to a surface of the PCB.

15. The method of Claim 12 or 13, the one or more post-fabrication processes comprising:
one or more manual pick-and-place processes; and
a solder reflow process configured to mount the at least one antenna element to a surface of the PCB.
